# EUROPEAN PATENT APPLICATION

(11) **EP 4 787 436 A1**
(43) Date of publication of application: **05.08.2026**
(21) Application number: 25172491.0
(22) Date of filing: 25.04.2025
(51) Int. Cl.: H01L 23/473, H01L 23/367, H10D 62/10, H01L 23/373

(54) **SEMICONDUCTOR ASSEMBLIES AND METHODS FOR COOLING A SEMICONDUCTOR ASSEMBLY AND A METHOD FOR MANUFACTURING A SEMICONDUCTOR ASSEMBLY**

(30) Priority: 04.02.2025 DE 102025104103
(71) Applicant: Corintis SA, 1015 Lausanne (CH)
(72) Inventor: FAHRNI, Malik, 1018 Lausanne (CH); TEODORO, Federica, 1018 Lausanne (CH)
(74) Representative: Fuchs Patentanwälte Partnerschaft mbB

(57) **Abstract**

The invention concerns a semiconductor assembly (1) and methods of manufacturing and cooling same. the semiconductor assembly (1) comprises:
- at least one first chip (10) and at least one second chip (12), wherein the first chip (10) is provided with at least one cooling structure (42) through which cooling fluid can flow;
- a manifold having at least one inlet port (36) for receiving a cooling fluid, and at least one outlet port (38) for releasing the cooling fluid;
- at least one cover member (14) having a first face (50) that is arranged opposite to at least a section of a first surface (52) of the at least one second chip (12), wherein a space (48) in which cooling fluid can flow is defined between the first face (50) and first surface (52) and the space (48) is fluidically connected to the manifold (34);
- at least a first sealing member (18) at least a section of which is arranged between the manifold (34) and the first chip (10), wherein the first sealing member (18) comprises at least one fluid opening (22) that fluidically connects the cooling structure (42) of the first chip (10) and the manifold (34),
wherein the cover member (14) is more rigid and/or harder than the first sealing member (18), in particular at least 50-times more rigid and/or at least 2-times harder.

## Description

The present invention concerns semiconductor assemblies, a method for cooling semiconductor assemblies, and a method of manufacturing a semiconductor assembly.

### Background

Liquid cooling is an established way to cool down high-power integrated circuits and other semiconductor devices. It is known that integrating micro-scale cooling features directly inside a semiconductor chip (such as integrated cooling channels which are e.g. etched directly into the semiconductor chip) can lead to high cooling performance, due to the absence of thermal interface material, and the high surface-area-to-volume ratio that microstructures offer.

However, not all semiconductor chips have the possibility to accept integrated cooling features. For example, some chips such as memory chips, may comprise several vertically-stacked layers of transistors, which results in less depth available for etching integrated cooling channels into the chips. Therefore, many memory chips are not suitable to have integrated cooling features. In another example, certain semiconductor chips do not produce high heat regularly (i.e. heat above a predefined threshold) during operation and so are not in need of integrated cooling features.

Additional processing steps are required for forming integrated cooling features of the above discussed kinds. These additional processing steps may be complex and increase the production costs of the semiconductor chip. Accordingly, if a chip does not produce high heat regularly then the cost of providing the integrated cooling features may outweigh the convenience of having the integrated cooling feature when the chip does ever heat to a high heat (high temperature). If the chip does ever heat to a high heat (high temperature) then there is a risk that the chip will become damaged. Semiconductor chips that do not produce high heat during operation may be fabricated using a different manufacturing process without the tools necessary to form integrated cooling features in the chip.

Accordingly, many semiconductor assemblies that exist today have disaggregated chip configurations, wherein the semiconductor assembly comprises one or more semiconductor chips which can have integrated cooling features (such as integrated cooling channels along which a cooling fluid can flow) and one or more other semiconductor chips which can or even need to be without integrated cooling features within the same assembly.

For such disaggregated chip assemblies the cooling system can be used to cool all chips in the assembly. Such cooling systems may comprise a spacer layer defining a chip cooling channel extending along both of a chip having integrated cooling features and a chip having no such integrated cooling features.

While this existing solution provides certain advantages, it has been determined that cooling efficiency might still be improved.

### Brief Summary of the Invention

This object is addressed by the invention defined in the independent claims. Advantageous embodiments are defined in the dependent claims, in this description and in the figures.

Accordingly, a semiconductor assembly is disclosed, the semiconductor assembly comprising:
- at least one first chip and at least one second chip, wherein the first chip is provided with at least one cooling structure through which cooling fluid can flow, put differently: the at least one cooling structure is configured to guide cooling fluid and/or to be flowed through by cooling fluid;
- a manifold having at least one inlet port (in brief: inlet) for receiving a cooling fluid, and at least one outlet port (in brief: outlet) for releasing the cooling fluid;
- at least one cover member having a first face that is arranged opposite to at least a section of a first surface of the at least one second chip, wherein a space in which cooling fluid can flow is defined between the first face and first surface and the space is fluidically connected to the manifold, put differently: the space is configured to guide cooling fluid and/or to be flowed through by cooling fluid;
- at least a first sealing member at least a section of which is arranged between the manifold and the first chip, wherein the first sealing member comprises at least one fluid opening that fluidically connects the at least one cooling structure of the first chip and the manifold.

The cover member can be more rigid and/or harder than the first sealing member, in particular at least 50-times more rigid and/or at least 2-times harder. The cover member can be up to 50,000-times more rigid and/or up to 5,000-times harder than the first sealing member.

For example, the cover member may be at least 75-times more rigid or at least 100-times more rigid and/or at least 200-times more rigid than the first sealing member. The rigidity may e.g. be selected so that the cover member is not deformable when applying the cooling fluid pressure and/or at most deformable to a lesser degree compared to the first sealing member. The first sealing member, on the other hand, may generally be elastically deformable when applying the cooling fluid pressure. The rigidity of the cover member and the first sealing can be measured or defined as a stiffness, e.g. in the unit of Newton per meter. Additionally or alternatively, parameters such as a flexural rigidity and/or torsional rigidity may be considered and/or the Young's modulus which may increase with increasing stiffness.

Regarding hardness, the cover member may at least be 5-times harder than the first sealing member and/or at least 8-times harder and/or at least 10-times harder. Regarding the first sealing member, in particular if it comprises or is made of an elastic material or another plastic material, the hardness may e.g. be measured as shore hardness. Regarding the cover member, in particular if it comprises or is made of a metallic material or a rigid plastic material, the hardness may e.g. be measured as Vickers hardness, Rockwell hardness or Brinell hardness. To compare the hardness values, empirical conversion charts or conversion formulas for the material of the first sealing member and/or of the cover member to a hardness scale used for measuring hardness of the respective other member can be referred to or can be determined. Additionally or alternatively, both of the first sealing member and/or cover member may be tested in terms of hardness with the same measurement method, e.g. to determine a Shore, Brinell, Vickers, or Rockwell hardness for both of these members.

With the semiconductor assembly disclosed herein, a comparatively hard and/or rigid cover member can be embedded into or can otherwise be combined with a comparatively elastic and soft first sealing member. This way, the first sealing member can provide a reliable sealing effect e.g. by enabling close fluid-tight contacts with adjacent components. The cover member, on the other hand, can provide and maintain reliable dimensions of the space that is usable for guiding cooling fluid close to and along the second chips. In other words, the cover member can locally stiffen the semiconductor assembly so as to maintain the space open and ensure that a channel formed thereby and has preferred and stable dimensions. Nonetheless, especially according to the below discussed embodiments, the cover member can still be deformable to adjust to a surface curvature of warpage of the second chips as is often present due to production tolerances.

By providing the defined space that is at least partially bounded by the cover member and the elastic first sealing member, cooling fluid can be guided in suitable and individually adjusted manners along the first and second chips to achieve a reliable cooling. For example, the flow conditions and/or flow volumes of the cooling fluid along each of the first and second chip may be precisely controlled by said structures, while reducing or even preventing uncontrolled cross flows of cooling fluid between the chips, in particular by means of the sealing function of the elastic first sealing member. According to some embodiments, the cooling fluid may flow along one of the first and second chips before flowing along the respective other. This, however, may not represent an uncontrolled cross flow but rather a controlled flow succession or a controlled flow along structurally defined fluid paths that are connected in series.

The first sealing member or in other words elastic sealing gasket provided around the cover member further blocks the cooling fluid from contacting any organic compounds (e.g., epoxy, resin, molding compound) that fill the gap between the different chips. This prevents fluid from getting in contact with organic material as it could otherwise absorb moisture.

Cover member as used herein can also be named fluidic layer or manifold layer.

The cooling structure of the first chip can comprise at least one cooling channel. The cooling structure of the first chip can comprise a plurality of cooling channels or a network of cooling channels.

According to a further embodiment, the first chip can comprise at least one integrated cooling channel along which cooling fluid can flow, put differently: the integrated cooling channel can be configured to guide cooling fluid and/or to be flowed through by cooling fluid. The integrated cooling channel can form the at least one cooling structure.

The term integrated cooling channel can mean herein that the cooling channel is provided integrally in the respective chip or in other words embedded in the respective chip. For example, the integrated cooling channel can be etched, engraved or otherwise provided in the chip, in particular located on the surface of the chip.

Alternatively or in addition, the first chip can have a cold plate and/or cooling features bonded to its surface that form the at least one cooling structure.

According to a further embodiment, the second chip is free of integrated cooling channels.

For example, the first surface of the second chip may be smooth and/or may be approximately planar. Nonetheless, it may to some degree be curved and/or warped as indicated above. For example, there may be no cooling channels that are etched as recesses, in particular elongated recesses, into the first surface of the second chip. For certain types of chips, providing such integrated cooling channels may not be possible due to the hardware structure. Nonetheless, the disclosed cover member and the space bounded thereby may help to ensure that sufficient room along which the cooling fluid can flow is provided close and preferably in direct contact with the second chip.

According to another embodiment, the second chip is provided with integrated cooling channels, that are e.g. etched into its first surface. In such a case, however, the integrated cooling channels can be different from those optionally provided in the first chip. In particular, there may be less integrated cooling channels in the second chip compared to the first chip. Additionally or alternatively, at least one of the following differences may exist:
- a combined length and/or a combined volume of the cooling channels integrated into the first chip is less compared to the cooling channels integrated into the second chip;
- an average flow cross-section and/or a maximum flow cross-section of the cooling channels integrated into the first chip is less compared to the cooling channels integrated into the second chip.

This may take the limited room into account that can be available for forming integrated cooling channels in the second chip compared to the first chip. In such a case, the presently disclosed space enclosed between the cover member and second chip may provide an additional cooling capability to, in combination with the optional integrated cooling channels of the second chip, satisfy the cooling needs of the second chip.

According to a further embodiment, the cover member comprises or is made of:
- stainless steel or another metallic material, wherein a Young's modulus of the cover member may e.g. be at least 190 GPa and/or up to 210 GPa; and/or
- a polymer, such as PEEK, or another plastic material, wherein a shore hardness of the cover member may e.g. be at least D 80 and/or up to D 90; and/or wherein a Young's modulus may e.g. be at least 3.5 GPa and/or up to 4.1 GPa.

According to a further embodiment, the first sealing member comprises or is made of:
- an elastomeric material, such as FKM (fluorine rubber) or EPDM (ethylene propylene diene monomer rubber), wherein a shore hardness of the first sealing member may e.g. be at least A 30, at least A 40 and/or up to A 90; and/ or wherein a Young's modulus may e.g. be at least 5 MPa and/or up to 15 MPa.

According to one example, the cover member is flexibly deformable to adjust to a warpage or surface curvature of the second chip. For doing so, a material and/or a material thickness of the cover member may be appropriately selected. The flexibility may in particular be achievable under applied assembly forces and/or fluid pressure. The second chip may not be deformable or at least not to a similar degree, in particular under applied assembly forces and/or fluid pressure. This helps to maintain preferred dimensions of the space for guiding the cooling fluid, so as to provide preferred flow characteristics and improve cooling efficiency.

According to a further embodiment, the cover member has a flat and/or a sheet-like and/or layer-like shape. For example, the cover member may comprise or be made of a material sheet, such as a metallic sheet and/or plastic sheet. This may help to provide the above-discussed flexible deformability, while still enabling a sufficient rigidity.

According to one example, the at least one first chip is a processing chip or computing platform, such as a CPU, TPU or a GPU. Such a processing chip, or the first chip in general, may be marked by a high cooling need compared to the second chip.

Additionally or alternatively, the at least one second chip can be a memory chip, such as a HBM, high bandwidth memory. Such chips are typically not capable of having integrated cooling channels, so that the presently disclosed space for guiding cooling fluid between the cover member and second chip can help to provide sufficient cooling for the second chip.

In one embodiment, the semiconductor assembly comprises at least 2, or at least 4, or at least 6 second chips arranged in the periphery of the at least one first chip. For example, these second chips may be arranged and may in particular be aligned along at least one side of the first chip or long at least two different sides of the first chip, in particular along two opposite sides.

In one example, the cover member has a thickness that is:
- less than 2 mm, in particular less than 1 mm or less than 0.5 mm; and/or
- less than at most four times and/or at most twice the warpage or surface curvature of the second chip, in particular wherein said warpage or surface curvature is measured as a maximum displacement between the highest and lowest points of a common surface of the second chip, in particular the first surface discussed herein, the displacement e.g. being measured along a below-discussed height axis and/or a reference plane extending orthogonally to said height axis; and/or
- at least as large as a height of the space, in particular a maximum of average height, and/or not more than 100 times, or not more than 50 times, or not more than 10 times a height of the space.

Any thickness and any height values referred to in this disclosure may be measured along the same axis, in particular a height axis along which the components of the semiconductor assembly are stacked. Further details on the orientation of such a height axis are disclosed below in connection with the discussion of the figures. By providing the cover member with a respectively reduced thickness, its structural flexibility can be improved to adjust to a possible service curvature of the second chip.

According to a further example, the cover member extends oppositely to at least 50 % and/or at least 75 % of the first surface of the at least one second chip. This may help to guide cooling fluid along a sufficiently large surface area of the second chip to achieve sufficient cooling thereof.

According to a further example, the cover member comprises at least one recess at its first face that partially bounds at least a section of the space. The cover member may e.g. be machined or otherwise formed at its first face to provide said recess. This may enable providing a space of sufficient volume for receiving the cooling fluid, in particular without having to necessarily machine, etch or otherwise process the first surface of the second chip.

In one example, the cover member comprises at least one opening that is fluidically connected to the space. The opening may be or comprise a through-hole or through-slot. Cooling fluid may pass from one side of the cover member to the other side through said opening, and thereby into or out of the space.

In any of the embodiments disclosed herein, cooling fluid may be guided within or through the semiconductor assembly to flow in a direction along and in particular in parallel to the height axis and/or across different layers of the semiconductor assembly. The layers may be formed by distinct components of the semiconductor assembly that are stacked on top of one another, in particular along the height axis. For example, the cooling fluid may, at least for limited length, flow towards and/or away from any of the first and second chip, e.g. through the openings in the cover member or fluid openings in the first sealing member. This may resemble directly flowing towards the first and second chips, e.g. orthogonally towards or away from a first surface of the second chip and/or a main surface of the first chip. Accordingly, the cooling fluid may not only be guided along or in parallel to the first and second chips and their respective surfaces, which may nevertheless be possible. Providing respective degrees of freedom for the flow direction of the cooling fluid enables providing any of the fluid flows and in particular first and second fluid path disclosed herein, in particular at a limited overall length of said fluid flows and fluid paths.

According to a further embodiment, the space has a height of at least 20 µm and/or not more than 200 µm, in particular wherein the height is between 30 µm and 70 µm. For example, the height of the space may be 50 µm. By selecting a respective minimum height, excessive pressure drops of the cooling fluid can be limited. On the other hand, by selecting a respective maximum height, a sufficient cooling performance is ensured, e.g. by ensuring a sufficient volume flow and/or adequate flow rate of the cooling fluid through the space.

According to a further embodiment, the first sealing member is more elastic than the cover member, in particular at least 1.5-times or at least 10 times more elastic. The elasticity may be measured as a Young's modulus of the respective members. If the first sealing member comprises or is made of an elastomer and the cover member comprises or is made of a metallic or rigid plastic sheet, the elasticity of the first sealing member may be much higher compared to the cover member, e.g. by a factor of several thousand, such as at least 10,000 and/or up to 200,000 based on Young's modulus.

According to a further embodiment, the first sealing member receives at least a section of the cover member and/or wherein the first sealing member extends along at least a section of a circumference of the cover member. For example, the first sealing member may have at least one receiving opening that e.g. has a closed conference. The cover member may be inserted and in particular may be pushed into said receiving opening, so that it is held therein via a frictional fit and/or a force fit. Accordingly, the cover member and in particular circumferential outer walls thereof may contact walls of the receiving opening, in particular circumferential inner walls. The cover member may be sealingly received in the receiving opening, wherein the sealing in particular includes a fluid-tight sealing. Alternatively, the cover member may be directly formed or molded into the first sealing member, e.g. by an initially liquid material of the first sealing member hardening or curing at and/or around the cover member.

According to a further embodiment, the first sealing member is configured to position the cover member relative to the second chip. This may e.g. be achieved by the first sealing member being configured to hold the cover member in place, especially opposite to the second chip.

According to a further embodiment, the first sealing member has a thickness that exceeds a thickness of the cover member, in particular by at least 1.5-times. This may help to improve flexibility of the cover member and/or its general capability to adjust to a surface curvature and/or warpage of the second chip. On the other hand, this may help to ensure sufficient sealing capabilities of the first sealing member.

According to a further embodiment, the semiconductor assembly comprises at least a second sealing member that is arranged oppositely to and in particular in contact with at least a section of the second face of the cover member. For example, the second sealing member may be received in the same receiving opening of the first sealing member in which the cover member is received. The second sealing member may be configured to equalize a height difference between the first sealing member and the cover member. As a result, the arrangement of the first and second sealing member may jointly define a layer having a substantially flush or level outer surface e.g. facing away from the first and second chips.

According to a further embodiment, the second sealing member comprises at least one opening that is fluidically and/or structurally connected to the opening in the cover member.

According to a further embodiment, the first sealing member is arranged oppositely to and in particular in contact with at least a section of the second face of the cover member, in particular wherein the first sealing member has at least one opening that is fluidically and/or structurally connected to the opening in the cover member.

In this disclosure, a structural connection between structural features along or through which the cooling fluid can flow may generally include that these structural features, such as the above-mentioned openings, are arranged and/or aligned in such a way that they form a continuous channel structure. For example, said structural features may be directly aligned behind one another and/or merge seamlessly into each other and/or may directly be connected without intermediate other structural features and/or obstructions. Such an arrangement may help to ensure that fluid can flow successively through the structural features along a defined path and without being impeded.

According to a further embodiment, the at least one fluid opening of the first sealing member defines an elongated opening in the first sealing member, in particular having a length of more than 0.5 mm or more than 1 mm. This way, it can be arranged oppositely to and/or expose at least sections of a plurality of cooling structures of the first chip, see below. For example, the elongated opening in the first sealing member may extend at an angle to a plurality of said cooling structures, e.g. at least 45° angle or substantially orthogonally thereto. This angle may be defined with respect to a longitudinal axis of said cooling structures and specifically between longitudinal axes of cooling channels of the cooling structures and of the elongated opening.

According to a further embodiment, the least one fluid opening of the first sealing member is arranged oppositely to at least one section of the at least one cooling structure of the first chip. This may resemble an example of the above-discussed structural and fluidic connection between two structural features guiding cooling fluid.

According to a further embodiment, the first chip comprises a plurality of cooling structure or a cooling structure with a plurality of cooling features, such as cooling channels, and the at least one fluid opening is arranged oppositely to at least a section of each of said plurality of cooling structures, in particular wherein the fluid opening extends at an angle to said cooling channels of the cooling structure/s.

According to a further embodiment, the semiconductor assembly defines at least one first fluid path and at least one second fluid path, wherein the first fluid path is configured to guide cooling fluid across or through the cover member and into and/or out of the space. For example, there may be at least a first opening in the cover member through which cooling fluid can flow into the space and at least a second opening in the cover member, through which cooling fluid can flow out of the space. The first fluid path may extend along or through both of these openings as well as along or through the space. The second fluid path, on the other hand, may not extend through the space. The first fluid path may optionally not extend along any of the integrated cooling channels of the cooling structure of the first chip.

According to a further embodiment, the second fluid path is configured to guide cooling fluid across or through the first sealing member into and/or out of the at least one cooling structure of the first chip. For example, there may be at least a first opening in the first sealing member through which cooling fluid can flow into the cooling structure and at least a second opening in the first sealing member, through which cooling fluid can flow out of the cooling structure. The second fluid path may extend along or through both of these openings as well as along or through the cooling structure.

According to one embodiment, the first fluid path and second fluid path are fluidically separated. This helps to individually set precise flows and/or volume rates of cooling fluid along the first and second chips, respectively, in particular without any cross flows between said first and second fluid paths.

According to a further embodiment, the first fluid path and second fluid path are fluidically connected in series. For example, cooling fluid may flow along the entire length of one of the first and second fluid path before reaching the respective other one of the first and second fluid path. Again, there can be no intermediate cross flows between the first and second fluid paths, e.g. occurring at intermediate positions without having reached an end of the one of the first and second fluid paths along which the cooling fluid flows first.

Accordingly, in one embodiment, the semiconductor assembly is configured to avoid intermediate cross flows between the first and second fluid paths.

According to a further embodiment, the semiconductor assembly is configured to guide cooling fluid along the first fluid path before said cooling fluid enters the second fluid path. This means that the cooling fluid can cool the second chip ahead of the first chip. Given that according to embodiments, the cooling needs of the second ship can be lower than that of the first chip, this can still ensure a sufficient cooling of the first chip.

According to a further embodiment, at least one connecting section that fluidically connects the first and second fluid path, in particular when connected in series according to any of the embodiments disclosed herein, is formed in at least one of the first sealing member, the manifold, a below-discussed dividing member or the cover member. This connecting section may e.g. be provided by a connecting section in the dividing member, a connecting channel section in the manifold, a connecting section in the first sealing member, or a connecting channel section in the cover member. Any of these configurations can help to internally guide the cooling fluid along limited lengths from the first fluid path to the second fluid path, thereby improving cooling efficiency.

According to a further embodiment, the space provided by the cover member can comprise a second cooling structure with cooling channels, such as a network of cooling channels, and/or cooling features. In this case, the cover member can be a cold plate. More precisely, the cover member can in this case be a flexible cold plate that is deformable to adjust to a surface curvature of warpage of the second chips. To be sufficiently flexible, the cold plate can be a sheet metal cold plate.

The cold plate constituting the cover member can have a thickness as defined above referring to the cover member. For example, the cold plate can have a thickness between 2.5 mm and 1 mm, or between 2.2 mm and 1.4 mm. For example, in particular when a sheet metal cold plate is provided, the cold plate can have a thickness between 0.3 mm and 0.8 mm, or between 0.4 mm and 0.6 mm, or between 0.45 mm and 0.55 mm.

According to another aspect, a semiconductor assembly is disclosed, the semiconductor assembly comprising:
- at least one first chip and at least one second chip, wherein at least the second chip, or the first chip and the second chip each, comprises at least one integrated cooling channel along which cooling fluid can flow, put differently: the integrated cooling channel is configured to guide cooling fluid and/or to be flowed through by cooling fluid;
- a manifold having at least one inlet port (in brief: inlet) for receiving a cooling fluid, and at least one outlet port (in brief: outlet) for releasing the cooling fluid;
- at least one cover member having a first face that is arranged opposite to at least a section of a first surface of the at least one second chip, wherein a space in which cooling fluid can flow is defined between the first face and first surface and the space is fluidically connected to the manifold, put differently: the space is configured to guide cooling fluid and/or to be flowed through by cooling fluid;
- at least a first sealing member at least a section of which is arranged between the manifold and the first chip.

The first sealing member can comprise at least one fluid opening that fluidically connects the integrated cooling channel of the first chip and the manifold.

The space can have a height of at least 20 µm and/or not more than 200 µm, in particular wherein the height is between 30 µm and 70 µm, for example 50 µm.

The second chip can be provided with integrated cooling channels, that are e.g. etched into its first surface. The first chip can be provided with integrated cooling channels, that are e.g. etched into it. In such a case, however, the integrated cooling channels of the second chip can be different from those of the first chip. In particular, there may be less integrated cooling channels in the second chip compared to the first chip. Additionally or alternatively, at least one of the following differences may exist:
- a combined length and/or a combined volume of the cooling channels integrated into the first chip is less compared to the cooling channels integrated into the second chip;
- an average flow cross-section and/or a maximum flow cross-section of the cooling channels integrated into the first chip is less compared to the cooling channels integrated into the second chip.

Alternatively or in addition to an integrated cooling channel, the first chip can be provided with is with at least one cooling structure, such as a cold plate and/or cooling features bonded to its surface.

According to another aspect, a semiconductor assembly is disclosed, the semiconductor assembly comprising:
- at least one first chip and at least one second chip, wherein the first chip is provided with a cooling structure through which cooling fluid can flow, put differently: the integrated cooling structure is configured to guide cooling fluid and/or to be flowed through by cooling fluid;
- a manifold having at least one inlet port (in brief: inlet) for receiving a cooling fluid, and at least one outlet port (in brief: outlet) for releasing the cooling fluid;
- at least one cover member having a first face that is arranged opposite to at least a section of a first surface of the at least one second chip, wherein a space in which cooling fluid can flow is defined between the first face and first surface and the space is fluidically connected to the manifold, put differently: the space is configured to guide cooling fluid and/or to be flowed through by cooling fluid;
- at least a first sealing member at least a section of which is arranged between the manifold and the first chip, wherein the first sealing member comprises at least one fluid opening that fluidically connects the cooling structure of the first chip and the manifold, wherein the space has a height of at least 20 µm and/or not more than 200 µm, in particular wherein the height is between 30 µm and 70 µm, for example 50 µm.

According to another aspect, a semiconductor assembly is disclosed, the semiconductor assembly comprising:
- at least one first chip and at least one second chip, wherein the first chip is provided with a first cooling structure through which cooling fluid can flow;
- a manifold having at least one inlet port (in brief: inlet) for receiving a cooling fluid, and at least one outlet port (in brief: outlet) for releasing the cooling fluid;
- at least one cover member in form of a cold plate having a second cooling structure through which cooling fluid can flow, wherein the cold plate is arranged such that the second cooling structure contacts at least a section of a first surface of the at least one second chip, and the second cooling structure is fluidically connected to the manifold, put differently: the second cooling structure is configured to guide cooling fluid and/or to be flowed through by cooling fluid;
- at least a first sealing member at least a section of which is arranged between the manifold and the first chip, wherein the first sealing member comprises at least one fluid opening that fluidically connects the first cooling structure of the first chip and the manifold,
wherein the cold plate has a thickness between 2.5 mm and 1 mm, or between 2.2 mm and 1.4 mm, or between 0.8 mm and 0.3 mm, or between 0.6 mm and 0.4 mm, or between 0.55 mm and 0.45 mm.

The invention also concerns a method of cooling a semiconductor assembly according to any of the previous claims, the method comprising:
- guiding cooling fluid into the space between the first face of the cover member and first surface of the second chip, e.g. along a first fluid path as discussed above; and
- guiding cooling fluid into the cooling structure of the first chip, e.g. along a second fluid path as connected above .

According to one embodiment, the cooling fluid can also be guided out of this space and from there into the cooling structure of the second chip, e.g. by a respective connecting section discussed above. This may include or resemble an embodiment wherein the first and second fluid paths are connected in series. For example, the cooling fluid can be guided through a connecting section that is e.g. configured according to any of the above examples. This connecting section may connect a first fluid path extending along or through the space and a second fluid path extending along or through the cooling structure.

According to another embodiment, the cooling fluid that is guided into the space is guided out of the space and out of the outlet without being guided along the cooling structure. Additionally or alternatively, the cooling fluid that is guided into the cooling structure is guided out of the cooling structure and out of outlet without being guided along the space.

In one example, the cooling fluid is guided into the cooling structure from two different ends, in particular to opposite ends e.g. in case the cooling structure has an elongated and/or line-shaped form. Additionally or alternatively, the cooling fluid can be guided out of the cooling structure at a position between its both ends, in particular at a central position. From there, it may be guided out of the outlet, in particular without passing through the space for cooling the second chip.

The method for cooling a semiconductor assembly can comprise any further steps and measures to generate any cooling flows disclosed herein, in particular along any of the first and second fluid paths disclosed herein.

The invention also concerns a method of manufacturing a semiconductor assembly, the semiconductor assembly comprising
- at least one first chip and at least one second chip, wherein the first chip comprises one or more cooling structures or a cooling structure with one or more cooling features through which cooling fluid can flow;
- a manifold having an inlet port for receiving the cooling fluid, and an outlet port for releasing the cooling fluid;
- at least one cover member;
- at least a first sealing member,
   wherein the cover member is more rigid and/or harder than the first sealing member, in particular at least 50-times more rigid and/or at least 2-times harder,
wherein the method comprises:
- arranging the cover member so that a first face thereof is arranged opposite to at least a section of a first surface of the at least one second chip and a space is defined between the first face and the first surface, wherein the space is fluidically connected to the manifold;
- arranging at least a section of the first sealing member between the manifold and the first chip, wherein the first sealing member comprises a least one fluid opening that fluidically connects at least one of the cooling structures of the first chip and the manifold.

With this method, a semiconductor assembly according to any of the examples disclosed herein can be manufactured. Accordingly, the method may comprise any further measures or steps to manufacture a semiconductor assembly according to any of the examples disclosed herein.

Features, effects, examples and/or embodiments described with regard to one aspect of the disclosure can also apply to other aspects. Likewise, features, examples and/or embodiments described with regard to one aspect of the disclosure can also apply to the methods and vice versa.

Exemplary embodiments of the invention are disclosed in the description and are illustrated by the drawings. Same features may be marked with the same reference signs throughout the figures. When a plurality of instances of a feature is depicted in a figure, only selected ones of these instances may be provided with a respective reference sign.

### Brief Description of the Drawings

Fig. 1A-1G schematically illustrates a sequence of placing components of a semiconductor assembly to form the latter, the semiconductor assembly and the placing method resembling embodiments of the invention.
Fig. 2 is a cross-sectional view of part of a semiconductor assembly according to a further embodiment.
Fig. 3 is a top view of the semiconductor assembly of Fig. 2.
Fig. 4 is a top view of the semiconductor assembly of Figure 3 in a subsequent assembly state.
Fig. 5 is a top view of the semiconductor assembly of Figure 4 in a subsequent assembly state.
Fig. 6 is a cross-sectional view of a semiconductor assembly according to a further embodiment.
Fig. 7 is a cross-sectional view of a semiconductor assembly according to a further embodiment.
Fig. 8 is a cross-sectional view of a semiconductor assembly according to a further embodiment.
Fig. 9 is a cross-sectional view of a semiconductor assembly according to a further embodiment.
Fig. 10 is a top view of a semiconductor assembly according to a further embodiment.
Fig. 11 is a cross-sectional view of the semiconductor assembly of Fig. 10.
Fig. 12 is a top view of a semiconductor assembly according to a further embodiment.
Fig. 13 is a cross-sectional view of the semiconductor assembly of Fig. 12.
Fig. 14 is a top view of a semiconductor assembly according to a further embodiment.
Fig. 15 is a cross-sectional view of the semiconductor assembly of Fig. 14.
Fig. 16 is an overview of various arrangements of the openings on embodiments of the semiconductor assembly.

### Detailed Description of the Disclosure

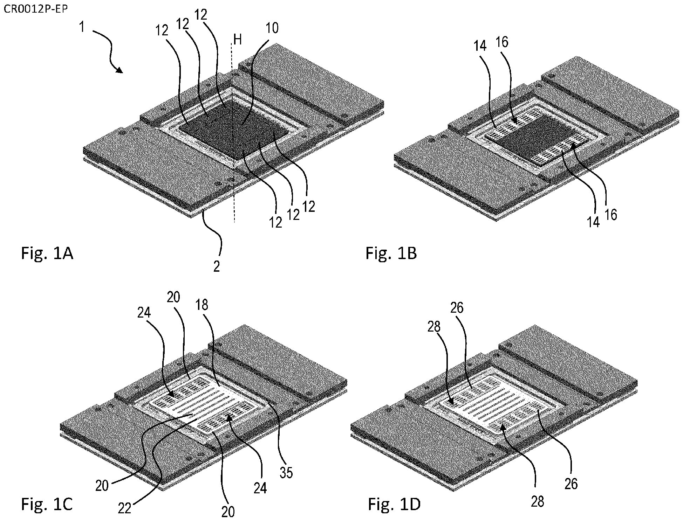

Figures 1A-G illustrate a semiconductor assembly 1 according to a first exemplary embodiment of the invention. Specifically, these figures show components of the semiconductor assembly 1 that are sequentially placed and in particular stacked on a substrate 2 to assemble the semiconductor assembly 1.

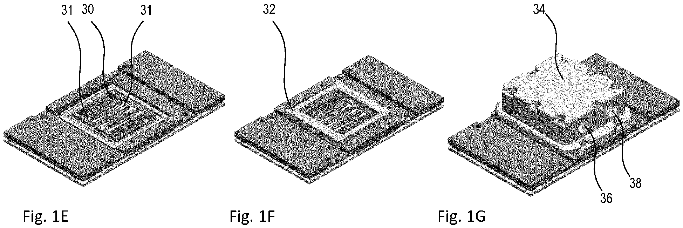

The illustrated sequence may resemble a sequence according to a method for producing a semiconductor assembly 1, the method resembling an embodiment of this invention. Yet, the illustrated sequence is not mandatory and the steps as illustrated Figures 1A-G may at least in part be carried out in a different sequence and/or in combined form. This e.g. concerns performing the measure of Figure 1C ahead of Figure 1B and/or jointly performing the measures of Figures 1C and 1D and/or jointly performing the measures of Figures 1E and 1F.

Figure 1 illustrates, as components of the semiconductor assembly 1, a first chip 10 and a plurality of second chips 12. The first chip 10 is a semiconductor chip which has a cooling structure in the form of integrated cooling features, such as the below discussed integrated cooling channels 42 along which cooling fluid can flow. This first chip 10 can be a CPU, Central Processing Unit, or GPU, Graphics Processing Unit. Each of the second chips 12 has no integrated cooling features, such as integrated cooling channels. According to other embodiments, such integrated cooling channels may be provided also in the second chips 12. In the shown example, each of the second chips 12 can be a high bandwidth memory chip, HWB.

The first and second chips 10, 12 are arranged side-by side on a substrate 2. The substrate 2 optionally forms part of the semiconductor assembly 1. More precisely, half of the second chips 12 are sequentially aligned along a first side of the first chip 10. The other half of the second chips 12 are sequentially aligned along a second side of the first chip 10, wherein the first and second side of the first chip 10 are opposite to one another. In the shown example, a non-limiting number of six second chips 12 is provided, but there may be less or more second chips 12, e.g. only one and/or any number between one and six or more than six. It may also be provided that the second chips 12 are arranged at a common side of the first chip 10 or at other sides than shown, in particular sides that are angled relative to one another and/or merge into one another.

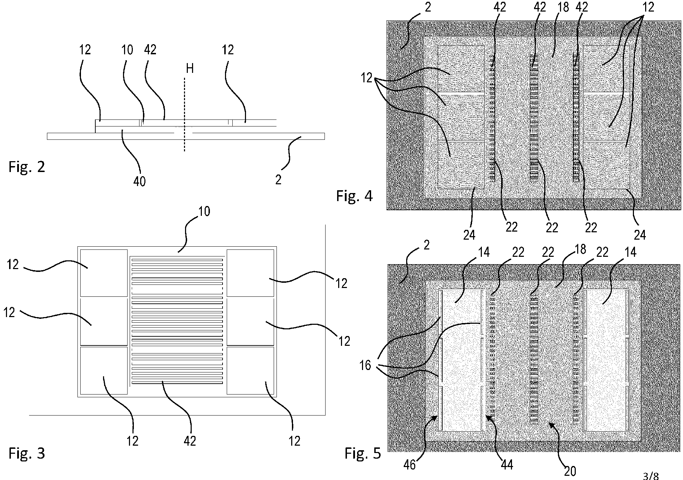

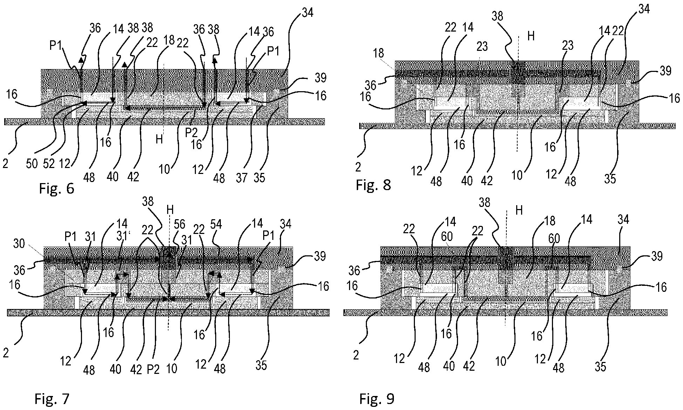

In a generally known manner, each of the first and second chips 10, 12 comprises at least one semiconductor die and/or is flat and/or has a layer-like shape and/or is a substantially rectangular component. Each of the first and second chips 10, 12 face the substrate 2 with one of its surfaces - also referred to as a second surface herein - and faces away from the substrate 2 with a respectively opposite side, i.e. with a first surface 52 (see figure 6) a main surface thereof. Electric connections between the substrate 2 and each of the first and second chips 10, 12 may be formed according to known examples, but are not specifically illustrated in the figures. This may include a non-illustrated optional interposer 40 that is arranged in between the first and second chips 10, 12 and the substrate 2, see the below discussion of Figure 2.

A height axis H is depicted in Fig. 1A. This height axis H is an axis along which the components of the semiconductor assembly 1 are stacked in the disclosed manner, without excluding that at least some of the components may at least partially overlap one another along the height axis H and/or are at least partially positioned at same heights. The height axis H extends orthogonally to the substrate 2. Further, it extends orthogonally to the above-discussed first and second surfaces of each of the first and second chips 10, 12.

Fig. 1B illustrates two cover members 14 as further components of the semiconductor assembly 1. The cover members 14 are arranged adjacent to the above-discussed opposite sides of the first chip 10 and on top of second chips 12. Each of the cover members 14 has a length that is at least three quarters as large as the respectively adjacent side of the first chip 10 and/or that exceeds a length of said respectively adjacent side. Each of the cover members 14 extends oppositely to and thereby covers the second chips 12 that are positioned at a respective side of the first chip 10. The opposite arrangement of each cover member 14 and the second chips 12 and/or the covering of said second chips 12 by a cover member 14 may in particular be present when viewed along the height axis H and/or in a top view, such as Figure 5.

The covering of the second chips 12 by a cover member 14 does not exclude that the cover member 14 has an opening 16 or other local through-holes. The cover members 14, although optionally locally interrupted by openings 16 as depicted, may extend along the first surfaces 52 (see Figure 6) of the second chips 12 which face away from the substrate 2, thereby covering them. In particular, the cover members 14 may extend along a majority and/or the entirety of the area of said first surfaces 52.

The number of the cover members 14 is not limited. There may be a single cover member 14 opposite to each second chip 12 or a plurality of adjacent cover members 12 that are arranged oppositely to each second chip 12. Covering a plurality of second chips 12, and in particular each of the second chips 12 arranged a common side of the first chip 10, by a single cover member 14 can improve structural integrity. Also, it may help to reduce production costs and/or improve cooling efficiency, e.g. by reducing structural interfaces and/or flowing obstacles for the cooling fluid near the second chips 12.

The openings 16 in each of the cover members 14 are configured as elongated through-slots, but may also have other shapes. In an exemplary manner, the openings 16 are arranged in an equidistantly spaced grid-like manner. This design of the openings 16 and their grid-like arrangement, alone or in combination, help to improve flow characteristics of the cooling fluid when crossing the cover members 14 through the openings 16.

The cover members 14 are made from a rigid, yet flexibly deformable material, in particular from a sheet-like material. Accordingly, the cover members 14 may resemble layer-like structures and/or define a distinct material layer within the overall semiconductor assembly 1. In the shown example, the cover members 14 are made from stainless steel sheets, but could also be made from a plastic material and in particular a plastic sheet. The cover members 14 are flexibly deformable, in particular when applying assembly forces during manufacture of the semiconductor assembly 1 and/or when applying fluid pressure of the cooling fluid during operation of the semiconductor assembly 1. This way, the cover members 14 may adjust to a potential warpage of the second chips 12.

Although not shown in Figures 1A-G, but elaborated upon further with respect to the subsequent Figures, there is a space 48 (see e.g. Figure 6) between the cover members 14 and second chips 12. This space, which may also be referred to as a gap or a fluid channel and/or may comprise at least one fluid channel, is fluidically connected to the openings 16. It can at least partially be bounded by non-illustrated recesses in the first face 50 of each cover member 14 that faces the second chips 12 (see Figure 6). The space 48 may resemble or define at least one hollow structure, or figuratively speaking: a pocket, for receiving and in particular for being flowed through by the cooling fluid.

In Figure 1B, first faces 50 of the cover members 14 that face the respectively opposite second chips 12 are facing away from the viewer. Instead, second faces of the cover members 14 that are opposite to and face away from said first faces 50 face the viewer.

Figure 1C shows that, as a further component of the semiconductor assembly 1, a first sealing member 18 is arranged on and in in particular in direct facing contact with the first chip 10. The first sealing member 18 is a gasket. It is made from a less rigid and/or less hard and/or more elastic material compared to a material of the cover members 14, e.g. an elastomeric material. The first sealing member 18 has a main section 20 that extends along and covers the opposite surface of the first chip 10. Within said main section 20, an exemplary number of fluid openings 22 is formed, only one of which is marked with a respective reference sign in Figure 1C. The fluid openings 22 provide fluid passages through or across the first sealing member 18. The fluid openings 18 can provide the I/O of the fluid to the integrated cooling structure on the chip 10. In an exemplary manner, the fluid openings 22 are configured as elongated through-slots. As apparent from the below figures, each fluid opening 22 is arranged opposite to at least a section of at least one integrated cooling channel 42 of the first chip 10.

The first sealing member 18 further comprises two receiving openings 24 that are adjacent to the main section 20. Each of the receiving openings 24 is opposite to and largely or fully exposes one or more of the cover members 14. The cover members 14 may at least partially be inserted into the receiving openings 24. For example, outwardly facing and/or circumferential edges of the cover members 14 rest against and in particular directly contact inner circumferential walls of the receiving openings 24. Put differently, the cover members 14 may each be pushed into and/or may be elastically or frictionally held in 1 of the receiving openings 24, e.g. with the receiving openings 24 providing an elastic holding force. For example, each receiving opening 24 extends circumferentially along and/or laterally encloses one of the cover members 14. The receiving openings 24 contribute to providing a lead-tight housing of the cover members 14.

Overall, the first sealing member 18 forms a layer within the semiconductor assembly 1 that has a closed outer circumference and/or that is laterally closed, while receiving or embedding and in particular holding the cover members 14 in a fluid-tight manner in its receiving openings 24. In an alternative example, the cover members 14 are molded into the first sealing member 18 or are adhered thereto. Due to the differences in hardness and/or rigidity, the cover members 14 can form locally harder and/or locally more rigid sections in the layer of the semiconductor assembly in which the first sealing member 18 extends.

Figure 1D shows second sealing members, optionally referred to as height adjustment gaskets 26, as further optional members of the semiconductor assembly 1. Each height adjustment gasket 26 is received in one of the receiving openings 24. The height adjustment gaskets 26 may be made from the same material as the first sealing member 18 or from another elastomeric material and/or another plastic material. The height adjustment gaskets 26 each comprise a plurality of openings 28. In the shown example, these are sized and/or shaped and/or arranged similar to the openings 16 of a respectively adjacent and/or contacted cover member 14. In particular, the openings 28 of each height adjustment gasket 26 are congruently arranged to the openings 16 of the respectively adjacent cover member 14. Each height adjustment gasket 26 may be dimensioned to equalize a height difference, or in other words: thickness difference, between the first sealing member 18 and a cover member 14. In the shown example, the first sealing member 18 has a larger height and/or thickness compared to the cover members 14. This help to increase reliability of a sealing function of the first sealing member 18, while enabling a thin and thus elastically deformable design of the cover members 14. The respective height or thickness values are measured along the height axis H.

Alternatively to the configuration of Figure 1D, where the height adjustment gaskets 26 and first sealing member 18 are separate components, these components may be provided in an integrated form. In this non-illustrated case, the first sealing member 18 may comprise sections formed similar to the height adjustment gaskets 26 above and/or in contact with the cover members 14. These sections may each comprise a recess facing the cover members 14, wherein said recesses are in particular provided in place of the above-discussed receiving openings 24. Each cover member 14 can at least partially be received in one of these recesses, essentially similar to being received in the receiving openings 24 discussed above.

Accordingly, in one example, the first sealing member 18 may, e.g. additionally to the above discussed main section 20, comprise non-illustrated covering sections, when each covering section covers one of the cover members 14. Also, said covering sections may comprise openings that may e.g. be configured according to any examples of the above-discussed openings 28 of the height adjustment gaskets 26. Further, said covering sections may each comprise an above-discussed recess for receiving one of the cover members 14.

Fig. 1E shows, as a further optional component of the semiconductor assembly 1, a dividing member 30 that can be introduced as a further layer within the semiconductor assembly 1. The dividing member 30 is placed on top of the outer surfaces of the first sealing member 18 and the height adjustment gaskets 26 that face the viewer in Figure 1D. The dividing member 30, which may be a one-part or multi-part member, may be formed from the same material as the first sealing member 18 or from another elastomeric material and/or another plastic material. The dividing member 30 comprises a number of cutouts 31, only some of which are marked with a respective reference sign in Fig. 1E. The cutouts 31 provide free spaces for the cooling fluid to pass through. The cutouts 31 are arranged and distributed, so as to enable or provide any flow direction and/or any fluid path and/or any flow sequence of the cooling fluid between the manifold and the first and second chips 10, 12 according to any of the examples discussed herein.

Accordingly, the cutouts 31 are arranged so that cooling fluid can be guided along the first surfaces of the second chips 12 and through the spaces 48 between said second chips 12 and the cover members 14 as well as into the integrated cooling channels 42 of the first chip 10. In this context, cross flows of cooling fluid may be prevented and at most a sequential flow may be enabled, such as first through at least one of the above-mentioned spaces 48 and then through the integrated cooling channels 42. Alternatively to such a sequential flow, the flow of the cooling fluid into and along the spaces 48 as well as into and along the integrated cooling channels 42 may be fluidically separated and may e.g. take place in parallel.

Fig. 1F shows, as a further optional component of the semiconductor assembly 1, a bounding member 32 that laterally and/or circumferentially encloses the first sealing member 18 and the optional dividing member 30. As a further optional feature, it exceeds a height of the stacked configuration depicted in figure 1D, i.e. exceeds a height of the divider 30 above the substrate 2 when placing the divider 30 on top of the first sealing member 18. The bounding member 32 may help to align and/or center all components and in particular the layers formed by said components of the configuration of Figure 1D relative to one another, in particular in directions parallel to the substrate 2. Additionally or alternatively, the bounding member 32 may help to keep the said components in position even when fluid pressure of the cooling fluid is applied.

Fig. 1F shows, as a further component of the semiconductor assembly 1, a manifold 34 that has at least two fluid ports in form of at least one inlet 36 and at least one outlet 38. The manifold 34 encases the components of the semiconductor assembly 1 depicted in figure Fig 1F in a fluid-tight manner. Cooling fluid can be provided to the inlet 36 by a non-depicted fluid pressure source and can be released to a non-depicted fluid reservoir from the outlet 38.

Fig.2 shows part of a semiconductor assembly 1 according to a further embodiment in a cross-sectional view. As evident from the following, this embodiment is largely similar to the previous one of Figures 1A-G. The cross-sectional plane contains the height axis H. The state of the semiconductor assembly 1 corresponds to that of Fig. 1A. Accordingly, first and second chips 10, 12 are provided that are configured according to the previous embodiment and that are similarly arranged relative to one another as shown in Fig. 1A. In the cross-sectional view of Figure 2, one of the integrated cooling channels 42 of the first chip 10 is visible and is intersected by the cross-sectional plane. Non-illustrated cooling fluid can flow along the integrated cooling channel 42. Any of the integrated cooling channels 42 of the first chip 10 may be etched into the first chip 10, e.g. from or into a surface of the first chip 10 facing upwards in Fig. 2. Accordingly, the integrated cooling channels 42 may form elongated surface recesses in the first chip 10.

As a non-limiting example, the first and second chips 10, 12 are attached to the substrate 2 via an interposer 40. The interposer 40 is arranged as a continuous layer in between the layer comprising the first and second chips 10, 12 and the substrate 2. The interposer 40 can be configured according to known examples and can e.g. facilitate electrical communication between the substrate 2 and the first and second chips 10, 12, mechanical support and/or thermal management.

Fig. 3 is a top view of the semiconductor assembly 1 in the stacking state, or with other words: assembly state, depicted in Fig. 2. The viewing direction of Fig. 3 is oriented along the height axis H of Fig. 2 and points vertically downwards. Again resembling Fig. 1A, three second chips 12 on each of two opposite sides of first chip 10 are shown. Further, the plurality of integrated cooling channels 42 of the first chip 10 are shown. These extend in between the opposite sides along which the second chips 12 are aligned as well as in parallel to one another. The cooling channels 42 are elongated. As a non-limiting example, the cooling channels 42 are straight.

Fig. 4 is a top view of the semiconductor assembly 1 of Figures 2 & 3 in a stacking state where a first sealing member 18 has been placed on top of the first and second chips 10, 12. Similar to the embodiment of Figure 1C, the first sealing member 18 optionally comprises receiving openings 24 for receiving cover members 14 (see Fig. 5). Each receiving opening 24 is located oppositely to and is in particular essentially congruently with a group of second chips 12 aligned along one of the two opposite sides of the first chip 10. Further, fluid openings 22 in a main section 20 of the first sealing member 18 similar to Figure 1C are shown, wherein the number of fluid openings 22 is only by way of example and can be less or more. Through said fluid openings 22, sections of the cooling channels 42 are exposed and visible, illustrating the fluidic connection to and from said cooling channels 42 provided by said fluid openings 22.

In Fig. 5, cover members 14 have been inserted the receiving openings 24 of Fig. 4, so that the stacking/assembly state resembles that of Fig. 1C of the previous embodiment. The cover members 14 are circumferentially surrounded and/or encased by the first sealing member 18, in particular wherein said circumferential contact is fluid tight.

Contrary to the previous embodiment, the openings 16 of the cover members 14 are not arranged in a uniform and equidistantly spaced grid, but in two rows along opposite edges of the cover members 16. Specifically, one set of openings 16 is aligned along a first edge 44 of each cover member 14 that is near the first chip 10 and one set of openings 16 is aligned along a second edge 46 of each cover member 14 that is further away from the first chip 10, with the first and second edge 44, 46 in particular extending in parallel to one another. In the depicted example of a rectangular cover member 14, the first and second edges 44, 46 extend along longer sides of said rectangular shape. A set of openings 16 extending along each of the first and second edges 44, 46 can comprise more or less openings 16 than the depicted three openings 16. Also, there can be more than a single line or column of openings 16 in each set, e.g. two or more columns that are in particular parallel to one another.

Figure 6 is a further cross-sectional view of an embodiment similar to that of Figures 2-5, with a difference concerning that the central or middle fluid opening 22 of Figure 5 is not present in Figure 6. Optionally, it could be added to include a further inlet 36 and/or outlet 38.

Further, additional components have been added compared to Figure 5. Specifically, a manifold 34 has been placed on top of the first sealing member 18 and cover members 14. This manifold 34 is supported by an optional frame member 35 that is also present in the previous embodiment, see Figure 1C for comparison. The frame member 35 encloses, but only optionally contacts and in the illustrated example does not contact, the stacked arrangement of the first and second chips 10, 12 as well as the optional interposer 40. Additionally or alternatively, the frame member 35 supports the first sealing member 18, e.g. by providing a seat 37 or edge that contacts part of an outer region of the surface of the first sealing member 18 that faces the substrate 2.

As a further optional feature, a seal 39, such as an O-ring, is arranged in between the manifold 34 and frame member 35 to provide a fluid-tight seal.

The manifold 34 has a plurality of inlets 36 and outlets 38. Specifically, for each cover member 14 and for the first sealing member 18, a pair of an inlet 36 and an outlet 38 is provided, each of which is fluidically connected to one of the openings 16 and fluid openings 22, respectively. In the shown example, the inlets 36 and outlets 38 directly contact and/or are congruently arranged with at least sections of said openings 16 and fluid openings 22, respectively.

The openings 16 of the cover members 14 are fluidically and/or structurally connected to, and in the shown example directly merge into and/or directly open into, the previously mentioned space 48 between the first side 50 of each cover member 14 and a first surface 52 of a respectively opposite second chip 12. The space 48 is configured to receive cooling fluid from one of the openings 16 that is connected to the inlet 36, so that the cooling fluid can flow within the space 48 along the first surfaces of the second chips 12 opposite a respective cover member 14. This space 48 is bounded by the first surface 52 of the second chips 12 that in the shown example is not specifically processed to enable the cooling and/or interact with the space 48. Accordingly, this first surface 22 is generally flat and smooth, but may experience warpage. In a non-illustrated embodiment, this first surface 52 can also at least partially be etched or otherwise processed to comprise integrated cooling channels, similar to the integrated cooling channels 42 of the first chip 10.

Further, the space 48 is bounded by a first side 50 of the respectively associated cover member 14. As indicated in Figure 6, this first side 50 has an elongated recess e.g. extending orthogonally to the image plane and oppositely to and/or along sections of each of the first surfaces 52 of the second chips 12.

Due to the cover members 14 being made from a more rigid and/or harder material compared to the first sealing member 18, the space 48 can reliably be maintained as a hollow volume and/or a gap within the semiconductor assembly 1, e.g. even when pressure is exerted on the members surrounding it. On the other hand, due to the cover members 14 being deformable to some degree, in particular due to any of the material selections and/or dimensions disclosed herein in particular in terms of thickness, possible curvatures or, in other words: warpages of the first surfaces 52 of the second chips 12 can to some degree be compensated for. Again, this may include the cover members 14 adjusting to said warpage a curvature, while reliably providing the space 48 and with any of the minimum heights disclosed herein, so that a sufficient cooling of the second chips 12 can be maintained.

From Figure 6, it is further apparent that the cover members 48 are circumferentially enclosed by the first sealing member 18, which helps to fluidically seal the spaces 48. Further, the first sealing member 18 fluidically seals the integrated cooling channels 42, e.g. by being oppositely arranged thereto along their entire lengths, while enabling local inflow into and outflow from the integrated cooling channels via its fluid openings 22.

By way of the embodiment of Figure 6, a cooling fluid flow along a first fluid path P1 through and across the cover members 14 is enabled as follows: Cooling fluid is received at a manifold inlet 36 and guided through at least one openings 16 of each cover member 14 into the space 48 to cool the respectively adjacent second chips 12. Within the space 48, the cooling flow flows towards another opening 16 of the cover member 14 connected to an in particular closer to and/or directly opposite to and/or directly joining a manifold outlet 38. This way, the cooling fluid is guided out of the space 48 after cooling the second chips 12 and out of the semiconductor assembly 1 via the manifold outlet 48.

Similarly, a second fluid path P2 is indicated by a dotted line for cooling the first chip 10. This fluid path P2 comprises the following: Cooling fluid is received at a manifold inlet 36 and guided through at least one fluid opening 22 of the first sealing member 18 into at least one of the integrated cooling channels 42 of the first chip 10. After having flowed along said integrated cooling channel 42, the cooling fluid reaches another fluid opening 22 of the first sealing member 18 which is in particular closer to and/or directly opposite to and/or directly joins a manifold outlet 38.

As can be gathered from Figure 6, the first and second fluid paths P1 and P2 are fludicially separated. This means that no crossflows or other exchanges of cooling fluid between said fluid paths P1 and P2 are possible within the semiconductor assembly 1. Accordingly, the cooling fluid flow can be adjusted to the individual cooling needs of the first and second chips 10, 12, respectively, which may help to enhance cooling efficiency.

It is to be noted that in particular the positioning of the openings 16 and fluid openings 22 can be identical to those of Figure 5, apart from the central fluid opening 22 as discussed above, but could also be different.

It is further noted that the flow paths can be chosen depending on the layout and power and/or heat fluxes of the first and second chips. The flow path can be from the first chip/s to the second chip/s or from the second chip/s to the first chip/s or parallel. In particular, by means of stacked layers, any desired orientation and cooling prioritization can be addressed.

Figure 7 shows a cross-sectional view similar to that of Figure 6 and of an embodiment that is more closely based on that of Figures 2-5. Specifically, the depicted first sealing member 18 also comprises the central fluid opening 22 depicted in Figure 5.

Again, additional components have been added compared to the state of Figure 5. Specifically, a divider 30 similar to that of Figure 1E is placed in between the layer formed by the first sealing member 18 and cover members 14 and the layer formed by the manifold 34. Cutouts 31 in the divider 30 are illustrated which provide defined fluidic connections between the inlet 36 and outlet 38 of the manifold 34 2 the spaces 48 below of the cover members 14 and 2 the integrated channels 42 of the first chip 10.

As a non-limiting example, the manifold 34 comprises an outlet 36 that fluidically connects to an internal fluid inlet channel 54 within the manifold 34. As illustrated, the fluid inlet channel 54 comprises several branches or local side-channels that are opposite to and/or join and/or merge into of the cutouts 31 of the divider 30. The manifold 34 also has an outlet channel 56 connected to the outlet 38. In Figure 7, for schematic illustration purposes, the outer channel 56 is depicted to extend in front of the inlet channel 54. The inlet channel 54 and outer channel 56 may actually be located in different sectional planes, other than suggested by Figure 7.

The divider 30 also comprises a connecting cutout 31' that fluidically connects at least one opening 16 of a cover member 14 to an adjacent fluid opening 22 of the first sealing member 18. Accordingly, the connecting cutout 31' provides a channel section that structurally and fluidically connects at least one opening 16 and at least one fluid opening 22. In the shown example, the connecting cutout 31' is not directly fluidically and structurally connected to the inlet 36 or outlet 38 and 2 the respective inlet and outlet channels 54, 56 of the manifold 34. Rather, it acts as an internal channel section within the divider 30 without directly merging into and/or merging with any channel sections of the manifold 34.

Still further, the divider 30 has at least one central cutout 31 that is fluidically and structurally connected to the outlet channel 56 of the manifold 34.

This way, the following fluid paths P1, P2 are defined for guiding fluid into and along the spaces 48 and integrated flowing channels 42: Through the manifold inlet 36, cooling fluid enters the inlet channel 54. From there, it is branched off through cutouts 31 in the divider 30 and flows through openings 16 of the cover members 14 into the spaces 48. Within said spaces 48, the cooling fluid flows and provides cooling as explained with respect to Figure 6. The cooling fluid 36 then enters a second fluid path P2 by way of a connecting cutout 31'. From there, it flows along the second fluid path P2 through one of the fluid openings 22 of the first sealing member 18 into and along at least one of the integrated cooling channels 42 of the first chip 10. In the shown example, each integrated cooling channel 42 has an inflow of cooling fluid on both of its ends and an intermediate outflow of cooling fluid in between said ends, e.g. at a location of a central fluid opening 22 in the first sealing member 18.

As evident from Figure 7, both ends of the integrated cooling channels 42 receive cooling fluid that has previously passed one of the spaces 48 below of one of the cover members 14. While according to a non-illustrated embodiment, cooling fluid could also only be received at one end of each integrated cooling channel 42, this double inflow at both ends can help to compensate for the increase of temperature of the cooling fluid after having already flown through one of the spaces 48.

Further, the fluid paths P1 and P2 are fluidly connected to and/or merge into one another, contrary to their separation in the embodiment of Figure 6. Yet, the fluid paths P1 and P2 are flown through by the cooling fluid in series, thus again limiting less efficient intermediate cross flows between said fluid paths P1 and P2. Specifically, cooling fluid only enters the integrated cooling channels 42 after it has passed one of the spaces 48, i.e. after it has already travelled along a respective first fluid path P1. Given that the cooling need of the second chips 12 is usually lower than that of the first chip 10, the cooling fluid can reach the integrated channels 42 with a cooling capacity sufficient to achieve a desired cooling of the first chip 10. Therefore, while an opposite flow direction can also be provided according to embodiments, flowing in the sequence as explained above and illustrated in Figure 7 can provide a particularly reliable cooling of the first and second chips 10, 12.

Figure 8 is a further cross-sectional view that is generally similar to that of Figures 6 and 7, but concerns a further embodiment of a semiconductor assembly 1. The manifold 34 is configured similar to the example of Figure 7, so that a repeated description thereof is omitted. Contrary to Figure 7, there is no separate flow divider 30, but the structures and functions of the flow divider have been integrated into the first sealing member 18. In other words, a single first sealing member 18 is provided that includes all the flow dividing and flow guiding capabilities of the flow divider 30 discussed with respect to Figure 7.

Accordingly, the first sealing member 18 comprises fluid openings 22 that are structurally and fluidically connecting the manifold inlet channel 54 to openings 16 of the cover members 14. Further, the first sealing member 18 comprises connecting sections 23 that, similar to the connecting cutouts 31'of Figure 7, structurally and fluidically connect openings 16 of the cover members 14 to the integrated cooling channels 42 of the first chip 10. As an optional feature similar to the connecting cutouts 31'of Figure 7, these connecting sections 23 are bounded and in particular fluidically sealed on at least one side by the manifold 34 and specifically a surface of the manifold 34 facing the substrate 2. With the configuration shown in Figure 8, identical fluid paths P1, P2 and fluid flows as explained above with respect to Figure 7 are provided, without these fluid paths P1, P2 being shown in Figure 8 in detail.

Figure 9 shows a further embodiment that is based on Figure 8 and is a comparable cross-section view. A difference to Figure 8 concerns the fact that at least a connecting channel section 60 for fluidically connecting the spaces 48 and integrated cooling channels 42 is formed in the manifold 34 and specifically as a recess on a surface of the manifold 34 facing the substrate 2. The connecting channel section 60 connects two adjacent fluid openings 22 in the first sealing member 18, so that cooling fluid may again flow along similar fluid paths P1, P2 from the spaces 48 into the integrated cooling channels 42, without these fluid paths P1, P2 being shown in Figure 9 in detail.

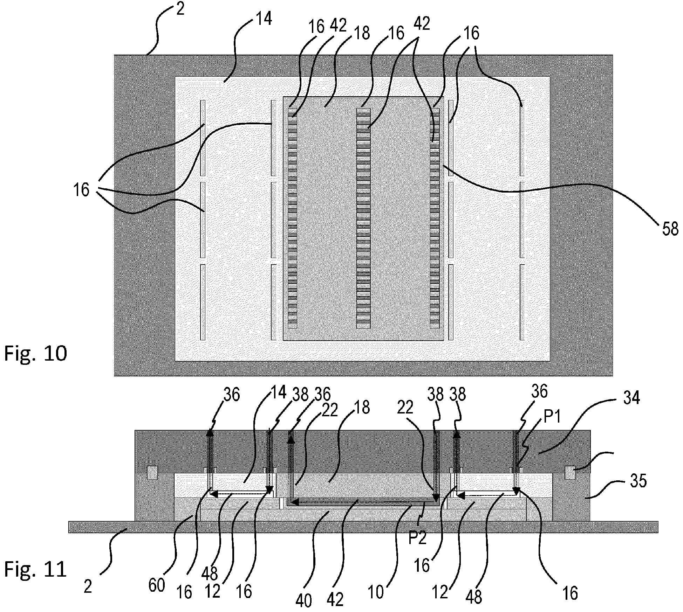

Figures 10 and 11 show a further embodiment, with Figure 10 showing a top view similar to Figures 4 & 5 and with Figure 11 showing a cross-sectional view similar to Figures 6-9.

First referring to Figure 11, it can be seen that in this embodiment physically separated fluid paths P1, P2 similar to the embodiment of Figure 6 are provided. The manifold 34 and the openings 16 and fluid openings 22, respectively, are structurally and fluidically connected similar to the embodiment of Figure 6.

A difference compared to the embodiment of Figure 6 exists and that there is a single integral cover member 14 that circumferentially surrounds and in particular receives the first sealing member 18. This can best be seen in the top view of Figure 10. The cover member 14 may at least in part be configured according to any example of the previously discussed cover members 14, in particular in terms of material, mechanical characteristics, bounding of spaces 48 with opposite second chips 12 and/or thickness. The depicted single cover member 14 comprises a central opening 58 that circumferentially surrounds the first sealing member 18. In particular, the first sealing member 18 may be inserted into said central opening 58 in a fluid tight manner. An outer circumferential edge of said first sealing member 18 may contact and in particular be elastically forced against inner circumferential walls of the central opening 58. This way, a reliable fluidic sealing of the integrated channels 42 is achieved.

As depicted in Figure 11, an optional sealing frame 60 can be provided to support a fluidic sealing of the spaces 48. The sealing frame 60 can be made of the same material as the first sealing member 18 or of another plastic material and in particular elastomeric material. The sealing frame 60 circumferentially encloses the arrangement of the first and second chips 10, 12 as well as the optional interposer 40. Also, it provides a surface facing away from the substrate 2 that is in direct facing contact with a side of the cover member 14 facing the substrate 2. Accordingly, in particular an outer circumferential edge of said side of the cover member 14 directly rests against the sealing frame 60 to provide a fluidic sealing effect. As a further optional feature and as correspondingly depicted in Figure 11, the sealing frame 60 also directly contacts in inner circumferential wall of the frame member 35 and/or a surface of the substrate 2 and/or outer edges of the second chips 12 and the optional interposer 40.

For the sake of completeness, it is noted that the first sealing member 18 does not comprise the previously discussed receiving openings 14, but is essentially reduced to its main portion 20 (see Figure 5) comprising the fluid openings 22. These fluid openings 22 are configured similar to the embodiment of Figures 4 & 5.

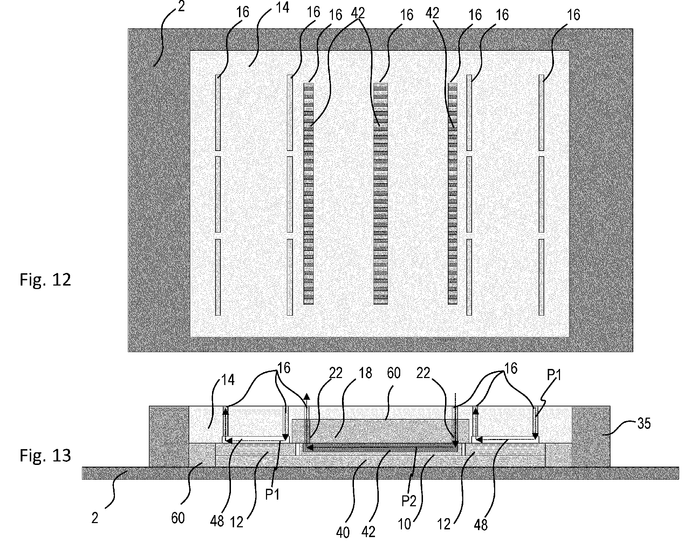

Figures 12 and 13 show a further embodiment, with Figure 12 showing a top view similar to Figure 10 and with Figure 13 showing a cross-sectional view similar to Figure 11. First referring to Figure 13, again a single cover member 14 is provided which is generally configured similar to the embodiment of Figures 10 and 11 but as a difference thereto also covers the first sealing member 18. Specifically, the cover member 14 extends along and opposite to the entire surface of the first sealing member 18 that faces away from the substrate 2. As an optional feature and as correspondingly depicted in Figure 13, the cover member 14 is in direct contact with the sealing member 18. Accordingly, the cover member 14 comprises a receiving recess 62 at its side facing the substrate 2 in which the sealing member 18 is received. As depicted, this may include the sealing member 18 being in contact with said recess 60 along its outer circumferential walls as well as with its surface that faces the recess 60. On the other hand, a surface of the sealing member 18 facing away from the recess 60 may be largely or fully exposed. A manifold 34 is not specifically depicted, but may nevertheless be present and may e.g. be configured similar to the manifold 34 of Figure 6.

From Figure 12 it can be seen, that in addition to the openings 16 that are placed identically to Figure 10 and Figure 5, the cover member 14 also comprises further openings 16 aligning with the fluid openings 22 of the first sealing member (see Figure 13) and with at least sections of the integrated channels 42 of the first chip 10. Accordingly, a second fluid path P2 along which cooling fluid flows through the integrated channels 42 also extends through openings 16 in the cover member 14. Other than that, the fluid paths P1 and P2 are similar to those of Figure 11.

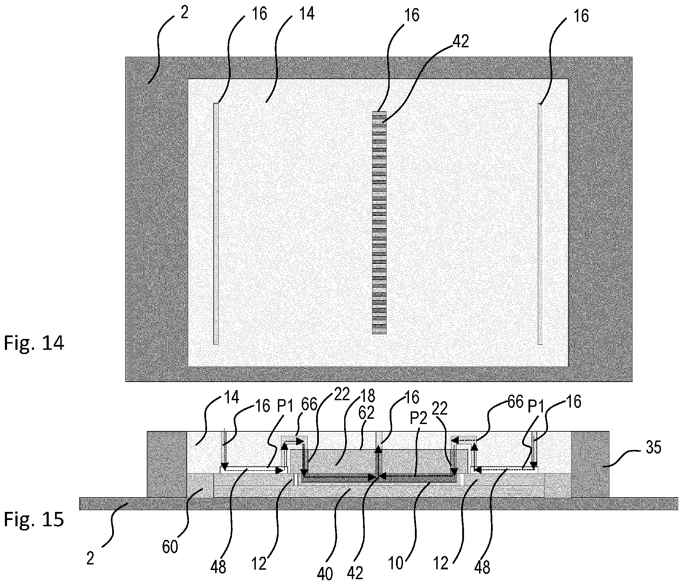

Figures 14 and 15 show a further embodiment, with Figure 14 showing a top view similar to Figure 10 and with Figure 15 showing a cross-sectional view similar to Figure 11. Similar to the previous embodiments of Figures 10 & 11 and 12 & 13, a single cover member 14 is provided. Similar to the embodiment of Figures 12 & 13, this cover member 14 also covers the first sealing member 16 and comprises a receiving recess 64 receiving the same. Again, a manifold 30 is not specifically depicted, but may nevertheless 62 be present and e.g. may be configured similar to the manifold 34 of Figures 7 or 8.

As can best be seen from the cross-sectional view of Figure 15, the cover member 14 comprises internal connecting channel sections 66 that, similar to the connecting cutouts 31'of Figure 7, structurally and fluidically connect the spaces 48 partially bounded by the cover member 14 to the integrated cooling channels 42 of the first chip 10. As an optional feature and similar to the connecting cutouts 31'of Figure 7, these connecting channel sections 66 are bounded and in particular fluidically sealed on at least one side by the non-illustrated manifold 34 and specifically a surface of the manifold 34 facing the substrate 2. With the configuration shown in Figure 15, identical fluid paths P1, P2 and fluid flows as explained above with respect to Figure 7 are enabled, i.e. a sequence of fluid paths P1, P2 connected by the connecting channel sections 64 and through which the cooling fluid flows one after the other.

Although not shown, in further embodiments and not limited to any specifics of the depicted embodiments, cooling elements may be provided in the space 48 to guide the flow of cooling fluid within said space 48. The cooling elements may e.g. comprise fins, pins, walls or other flow guiding structural features .

Further, a sequence of flowing along first and second fluid paths P1, P2 may include the following: The cooling fluid can flow along a first fluid path P1 through a first one of the spaces 48, from there along a second fluid path P2 and along the integrated cooling channels 42, and from there along a further first fluid path P1 through a second one of the spaces 48. With respect to e.g. Figure 7, this may include following through the left first fluid path P1, then along the entire second fluid path P2 without flowing towards the central outlet 38 in a central position, and flowing in a reverse direction to what is depicted in Fig. 7 along the right first fluid path P1.

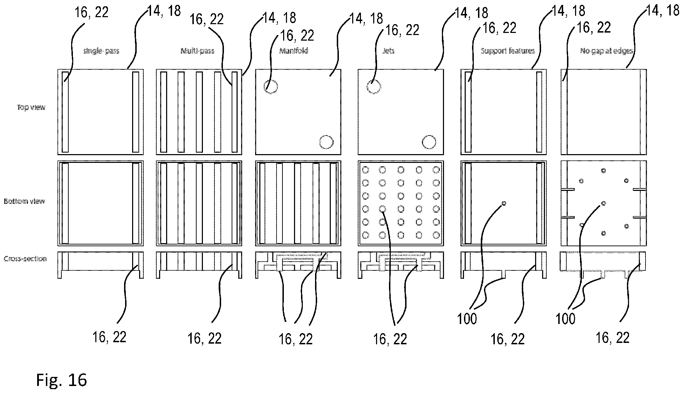

Figure 16 is an overview of possibilities for arranging openings 16 in a cover member 14 and/or arranging fluid openings 22 in a first sealing member 18, in particular at least in the main section thereof. The depicted variants may be combined with any of the further embodiments depicted herein or with any of the embodiments generally disclosed. Each variant is depicted in a column of Figure 16 by way of a top view, a bottom view and a cross-sectional view. The top view shows a surface facing away from a non-illustrated substrate 2, the bottom view shows a surface facing towards the substrate 2, the cross-sectional view concerns a cross-sectional plane extending orthogonally to the substrate 2.

From left to right in figure 16, the first variant illustrates elongated, slot -like opening 16, 22 that extend across the complete height of the cover member 14 and first sealing member 18, respectively. The second variant includes a plurality of such elongated, slot-like openings 16, 22 extending in parallel to one another and being aligned next to one another. The third variant includes local openings 16, 22 that are e.g. marked by circular shapes and which branch into elongated slot-like openings at a bottom face. This relation can in particular be derived from the cross-sectional view of this variant. The fourth variant corresponds to the third variant on its top side, but branches into a plurality of grid-like arranged single and in particular circular openings 16, 22 at the bottom side.

The fifth and sixth variants have openings 16, 22 similar to the first variant, with the sixth variant providing said openings 16, 22 directly at the edges of the respective component 14, 18. Further, the fifth and sixth variants add protruding support features 100, e.g. in form of support legs, at the bottom side of the respective component 14, 18. Support features can help to avoid warping of the cover member during compression. This applies in particular to cover members that are very thin and have a material stiffness (Young's Modulus) of 70 GPa or less.

In sum, figure 16 illustrates that the cooling fluid flow through the components 14, 18 can be suitably adjusted by placing and/or dimensioning and/or branching its openings 16, 22.

## Claims

1. A semiconductor assembly (1) comprising:
- at least one first chip (10) and at least one second chip (12), wherein the first chip (10) is provided with at least one cooling structure (42) through which cooling fluid can flow;
- a manifold having at least one inlet port (36) for receiving a cooling fluid, and at least one outlet port (38) for releasing the cooling fluid;
- at least one cover member (14) having a first face (50) that is arranged opposite to at least a section of a first surface (52) of the at least one second chip (12), wherein a space (48) in which cooling fluid can flow is defined between the first face (50) and first surface (52) and the space (48) is fluidically connected to the manifold (34);
- at least a first sealing member (18) at least a section of which is arranged between the manifold (34) and the first chip (10), wherein the first sealing member (18) comprises at least one fluid opening (22) that fluidically connects the cooling structure (42) of the first chip (10) and the manifold (34),
wherein the cover member (14) is more rigid and/or harder than the first sealing member (18), in particular at least 50-times more rigid and/or at least 2-times harder.

2. The semiconductor assembly (1) according to claim 1,
wherein the second chip (12) is free of integrated cooling channels, and/or
wherein the first chip (10) comprises at least one integrated cooling channel forming the cooling structure (42); and/or
wherein at least one of a) and b) is provided:
a) the cover member (14) comprises or is made of stainless steel or another metallic material, a polymer, such as PEEK, polyether ether ketone, or another plastic material;
b) the first sealing member (18) comprises or is made of an elastomeric material, such as FKM, fluorine rubber, or EPDM, ethylene propylene diene monomer rubber.

3. The semiconductor assembly (1) according to any of the previous claims,
wherein the cover member (14)
- is flexibly deformable to adjust to a warpage or surface curvature of the second chip (12), and/or
- has a flat and/or a sheet-like and/or layer-like shape, and/or
- has a thickness that is less than 2 mm, in particular less than 1 mm or less than 0.5 mm, and/or less than at most four times and/or at most twice the warpage or surface curvature of the second chip (12), and/or
- extends oppositely to at least 50 % and/or at least 75 % of the first surface (52) of the at least one second chip (12), and/or
- comprises at least one recess at its first face (50) that partially bounds at least a section of the space (48), and/or
- comprises at least one opening (16) that is fluidically connected to the space (48).

4. The semiconductor assembly (1) according to any of the previous claims,
wherein the at least one first chip (10) is a processing chip, such as a CPU or a GPU, and wherein the at least one second chip (12) is a memory chip, such as a HBM; and/or
wherein the semiconductor assembly (1) comprises at least 2, or at least 4, or at least 6, or at least 8 second chips (12) arranged in the periphery of the at least one first chip (10);
and/or
wherein the semiconductor assembly comprises at least 4, or at least 6, or at least 8, or at least 10, second chips (12) arranged in the periphery of at least two first chips (10).

5. The semiconductor assembly (1) according to any of the previous claims,
wherein the space (48) has a height of at least 20 µm and/or not more than 200 µm, in particular wherein the height is between 30 µm and 70 µm, for example 50 µm.

6. The semiconductor assembly (1) according to any of the previous claims,
wherein the first sealing member (18)
- is more elastic than the cover member (14), in particular at least 1.5-times more elastic, and/or
- receives at least a section of the cover member (14) and/or wherein the first sealing member (18) extends along at least a section of a circumference of the cover member (14), and/or
- is configured to position the cover member (14) relative to the second chip (12), and/or
- has a thickness that exceeds a thickness of the cover member (14), in particular by at least 1.5-times, and/or
- is arranged oppositely to and in particular in contact with at least a section of the second face of the cover member (14), in particular wherein the first sealing member (18) has at least one opening that is fluidically connected to the opening (16) in the cover member (14).

7. The semiconductor assembly (1) according to any of the previous claims,
wherein the semiconductor assembly (1) comprises at least a second sealing member (26) that is arranged oppositely to and in particular in contact with at least a section of a second face of cover member (14);
and/or
wherein the second sealing member (26) is configured to equalize a height difference between the first sealing member (18) and the cover member (14);
and/or
wherein the second sealing member (26) comprises at least one opening (28) that is fluidically connected to the opening (16) in the cover member (14).

8. The semiconductor assembly (1) according to any of the previous claims,
wherein the at least one fluid opening (22) of the first sealing member (18) defines an elongated opening in the first sealing member (18), in particular having a length of more than 0.5 mm or more than 1 mm;
and/or
wherein the least one fluid opening (22) of the first sealing member (18) is arranged oppositely to at least one section of the cooling structure (42) of the first chip (10); preferably wherein the first chip (10) comprises a plurality of cooling structures (42) or a cooling structure (42) with a plurality of cooling features and the at least one fluid opening (22) is arranged oppositely to at least a section of each of said plurality of cooling structures (42) or said cooling structure (42) with a plurality of cooling features, in particular wherein the fluid opening (22) extends at an angle to said integrated cooling structures (42) or cooling structure.

9. The semiconductor assembly (1) according to any of the previous claims,
wherein the semiconductor assembly (1) defines at least one first fluid path (P1) and at least one second fluid path (P2), wherein the first fluid path (P1) is configured to guide cooling fluid across the cover member (14) into and/or out of the space (48); preferably wherein the semiconductor assembly (1) is configured to avoid intermediate cross flows between the first and second fluid paths (P1, P2), in particular wherein the second fluid path (P2) is configured to guide cooling fluid across the first seal member (18) into and/or out of the cooling structure (42) of the first chip (10).

10. The semiconductor assembly (1) according to claim 9,
wherein the first fluid path (P1) and second fluid path (P2) are fluidically separated;
or
wherein the first fluid path (P1) and second fluid path (P2) are fluidically connected in series; preferably wherein the semiconductor assembly (1) is configured to guide cooling fluid along the first fluid path (P1) before said cooling fluid enters the second fluid path (P2).

11. The semiconductor assembly (1) according to claim 10,
wherein a connecting section (23, 31', 60, 66) that fluidically connects the first and second fluid path (P1, P2) is formed in at least one of the first seal member (18), the manifold (34), the cover member (14) and a dividing member (30).

12. A method of cooling a semiconductor assembly (1) according to any of the previous claims,
the method comprising:
- guiding cooling fluid into the space (48) between the first face (50) of the cover member (14) and first surface (52) of the second chip (12); and
- guiding cooling fluid into the cooling structure (42) of the first chip (10),
wherein preferably the cooling fluid is guided into the cooling structure (42) from two different ends of said cooling structure (42), in particular wherein the cooling fluid is guided out of the cooling structure (42) at a position in between said ends.

13. The method of claim 12, further comprising:
- guiding the cooling fluid out of the space (48) and from there into the cooling structure (42), preferably guiding the cooling fluid along a connecting section (23, 31', 60, 66) connecting a first fluid path (P1) extending along at least a section of the space (48) and a second fluid path (P2) extending along at least a section of the cooling structure (42).

14. The method of claim 12, wherein the cooling fluid that is guided into the space (48) is guided out of the space (48) and out of the outlet (38) without being guided along the cooling structure (42), and/or the cooling fluid that is guided into the cooling structure is guided out of the cooling structure (42) and out of the outlet (38) without being guided along the space (48):

15. A method of manufacturing a semiconductor assembly (1),
the semiconductor assembly (1) comprising
- at least one first chip (10) and at least one second chip (12), wherein the first chip (10) comprises one or more cooling structures (42) or a cooling structure with one or more cooling features along which cooling fluid can flow;
- a manifold (34) having an inlet port (36) for receiving the cooling fluid, and an outlet port (38) for releasing the cooling fluid;
- at least one cover member (14);
- at least a first sealing member (18),
wherein the cover member (14) is more rigid and/or harder than the first sealing member (18), in particular at least 50-times more rigid and/or at least 2-times harder,
wherein the method comprises:
- arranging the cover member (14) so that a first face (50) thereof is arranged opposite to at least a section of a first surface (52) of the at least one second chip (12) and a space (48) is defined between the first face (50) and the first surface (52), wherein the space (48) is fluidically connected to the manifold (34);
- arranging at least a section of the first sealing member (18) between the manifold (34) and the first chip (10), wherein the first sealing member (18) comprises a least one fluid opening (22) that fluidically connects at least one of the cooling structure (42) of the first chip (10) and the manifold (34).
